# EUROPÄISCHE PATENTANMELDUNG

(11) **EP 1 792 693 A2**
(43) Veröffentlichungstag der Anmeldung: **06.06.2007**
(21) Anmeldenummer: 06023612.2
(22) Anmeldetag: 14.11.2006
(51) Int. Cl.: B25J 7/00, B25J 9/10, G01H 13/00, G01L 1/10

(54) **Vorrichtung zum Verlagern von Endeffektoren an Mess- oder Handhabungseinrichtungen sowie Verfahren zur Bestimmung der Kontaktkraft oder der Position eines Endeffektors**

(30) Priorität: 14.11.2005 DE 102005054551
(71) Anmelder: Carl von Ossietzky Universität Oldenburg, 26111 Oldenburg (DE)
(72) Erfinder: Wich, Thomas, 26123 Oldenburg (DE); Hänssler, Olaf C., 26135 Oldenburg (DE); Kamenik, Jens, 26131 Oldenburg (DE)
(74) Vertreter: Stornebel, Kai

(57) **Zusammenfassung**

Die Erfindung betrifft eine Vorrichtung zum Verlagern von Endeffektoren (1) an Mess- oder Handhabungseinrichtungen mit zumindest zwei elektrischen Antrieben (4,5), die mit dem Endeffektor (1) gekoppelt sind sowie ein Verfahren zur Bestimmung der Kontaktkraft oder der Position eines Endeffektors, insbesondere eines Mikromanipulators, zu einem Objekt, der zumindest zwei elektrische Antriebe (4,5) aufweist, die gegeneinander beweglich sind. Aufgabe der vorliegenden Erfindung ist es, eine vereinfachte Vorrichtung und ein vereinfachtes Verfahren zur Bereitstellung eines taktilen Sensors anzugeben, mit dem es möglich ist, den Kontakt zwischen zwei Objekten zu detektieren und gegebenenfalls die Kontaktkraft zu bestimmen. Dazu sind die Antriebe (4,5) über Anlenkpunkte (2,3) mit dem Endeffektor (1) gekoppelt und üben eine Linearbewegung aus, wobei zumindest ein Antrieb (4,5) mit einem Frequenzgenerator (8,11) gekoppelt und mit einem Resonanzsignal (RS) zusätzlich zu einem Antriebssignal (AS1,AS2) beaufschlagt ist und die Antriebe (4,5) mit einer Signalanalyseeinheit (13) gekoppelt sind, die eine Veränderung des Resonanzsignals (RS) bei Kontakt mit einem Objekt auswertet.

## Beschreibung

Die Erfindung betrifft eine Vorrichtung zum Verlagern von Endeffektoren an Mess- oder Handhabungseinrichtungen mit zumindest zwei elektrischen Antrieben, die mit dem Endeffektor gekoppelt sind, sowie ein Verfahren zur Bestimmung der Kontaktkraft oder der Position eines Endeffektors, insbesondere eines Mikromanipulators, zu einem Objekt, der zumindest zwei elektrische Antriebe aufweist, die gegeneinander beweglich sind.

In vielen Bereichen der Handhabungs- und der Messtechnik ist es notwendig, die Position eines Greifers bzw. eines Greifelementes oder eines Messtasters gegenüber dem zu greifenden Objekt bzw. dem Messobjekt zu bestimmen. Dies kann mit Hilfe vielfältiger Instrumente geschehen, beispielsweise mit Abstandssensoren oder mit bildverarbeitenden Systemen. Gerade bei bildverarbeitenden Systemen werden jedoch meist nur zweidimensionale Bilddaten verarbeitet, so dass die dritte Dimension dem System vorenthalten bleibt. Bei einem Einsatz von Kamerasystemen oder optischen Mikroskopen kann die Lage des Greifers oder Messtasters und des zu ergreifenden Objektes bzw. des Messobjektes zueinander durch Ändern der Fokuslage herausgefunden werden. Durch wechselndes Fokussieren des Endeffektors und des Objektes kann der relative Abstand zueinander bestimmt werden. Ebenso kann aufgrund der dadurch gewonnenen Daten eine Steuerung der Bewegung des Endeffektors erfolgen, eine langsame Annäherung an das Objekt bzw. der Greiferelemente aneinander und schließlich ein Antasten kann somit durchgeführt werden.

Speziell im Mikro- und Nanometerbereich wird für solche Handhabungs- oder Messaufgaben als bildgebender Sensor oft ein Rasterelektronenmikroskop (REM) eingesetzt. Durch dessen sehr hohe Schärfentiefe stößt das oben beschriebene Verfahren sehr schnell an seine Grenzen, insbesondere im Hinblick auf die Automatisierung solcher Prozesse. Bei dem oben genannten Verfahren ist die Messung der Greif- bzw. Antastkräfte nur möglich, wenn das greifende bzw. antastende System oder ein Teil des Endeffektors mit einem Kraftsensor ausgestattet ist.

Ein Verfahren und eine Vorrichtung zur automatischen Positionierung eines Bauteils auf einer Fügeposition einer Montageebene mittels eines Greifers, der mittels eines Greifantriebes und eines Feinpositionierantriebes eines Handhabungsgerätes verstellbar ist und ein optisches Mess- und Bildverarbeitungssystem zur Ermittlung der Fügeposition und der Bauteilposition des vom Greifer gehaltenen Bauteils aufweist, ist in der DE 100 12 081 A1 beschrieben.

Aus der DE 102 00 834 A1 ist eine Kraftmess- und Greifvorrichtung zum Abtasten und/oder Greifen von nanometergroßen Objekten in unterschiedlichen Medien mit einem ersten und einem zweiten Arm bekannt, die beabstandet und im Wesentlichen parallel zueinander verlaufen und jeweils eine Längsachse aufweisen. Weiterhin ist eine erste und eine zweite Greif- und Kraftmesseinheit vorgesehen, die jeweils den Armen zugeordnet sind. Beide Arme sind über ein Gelenkmittel miteinander verbunden, wobei das Gelenkmittel die beiden Arme in einem ersten und einem zweiten Gelenksabschnitt teilt und das Gelenkmittel so ausgelegt ist, dass es die Schwenkbewegung zumindest eines Armes um das Gelenkmittel und damit einer Messeinheit in einer Ebene ermöglicht, die parallel zur Längsebene beider Achsen ist. Es kann vorgesehen sein, dass jede Messeinheit ein Trägerelement und einen Kraftmessbalken aufweist.

Die DE 103 04 970 A1 beschreibt eine Positioniereinheit mit einer Welle, die drehbar angetrieben und in Achsrichtung verschiebbar in einem Gehäuse gelagert ist und einen linearen Antrieb aufweist. Die Antriebe können die Welle drehend oder linear verlagern. An der Welle ist ein Kraftsensor gekoppelt, der eine in Achsrichtung wirkende Gegenkraft misst, die über ein Halteelement von außen eingeprägt wird, wobei der Kraftsensor ein von der Gegenkraft abhängiges Kraftsignal an den linearen Antrieb liefert, um die Geschwindigkeit und/oder die Beschleunigung bzw. die Antriebskraft der Linearbewegung zu beeinflussen.

Aus der DE 101 36 581 B4 ist ein kraftsensitiver Mikromanipulator und ein Verfahren zur Messung und/oder Regelung der Greifkraft eines Mikromanipulators bekannt, mit dem Gegenstände mit mikroskopischen Abmessungen greifbar sind, wobei der Mikromanipulator zwei gegeneinander verschiebliche Klemmbacken aufweist, zwischen denen ein Gegenstand unter Aufbringung einer Klemmkraft klemmbar ist. Eine der Klemmbacken ist als Teil einer Federzunge ausgebildet, die in Eigenschwingung versetzt wird, wobei die Änderung der Schwingung während der Berührung des Gegenstandes durch die Federzunge beobachtet wird, wobei aus der Änderung eine die Klemmkraft charakterisierende Größe berechnet und die Greifkraft anhand der charakterisierenden Größe gesteuert wird. Das Grundprinzip besteht darin, eine Greiferspitze mit einer Federzunge oder mit einer miniaturisierten Stimmgabel auszurüsten, diese mit einem separaten Schwingungsgenerator zur Schwingung anzuregen und das Schwingungsverhalten zu beobachten, wenn die Federzunge oder einer der beiden Zinken der Stimmgabel direkt oder indirekt mit dem zu greifenden oder detektierenden Gegenstand in Berührungskontakt kommt. Die Ausbildung eines Greiferelementes als Stimmgabel ist aufwendig und bei beschränkten Platzverhältnissen nicht möglich.

Aufgabe der vorliegenden Erfindung ist es, eine vereinfachte Vorrichtung und ein vereinfachtes Verfahren zur Bereitstellung eines taktilen Sensors anzugeben, mit dem dem es möglich ist, den Kontakt zwischen zwei Objekten zu detektieren und gegebenenfalls die Kontaktkraft zu bestimmen.

Erfindungsgemäß wird diese Aufgabe durch eine Vorrichtung mit den Merkmalen des Anspruchs 1 sowie durch ein Verfahren mit den Merkmalen des Anspruchs 12 gelöst. Vorteilhafte Ausgestaltungen und Weiterbildungen der Erfindung sind in den Unteransprüchen beschrieben.

Die erfindungsgemäße Vorrichtung zur Verlagerung von Endeffektoren an Mess- oder Handhabungseinrichtungen mit zumindest zwei elektrischen Antrieben, die mit dem Endeffektor gekoppelt sind, sieht vor, dass die Antriebe über Anlenkpunkte mit dem Endeffektor gekoppelt und eine Linearbewegung oder Rotationsbewegung ausüben, wobei zumindest ein Antrieb mit einem Frequenzgenerator gekoppelt und mit einem Resonanzsignal zusätzlich zu einem Antriebssignal beaufschlagt ist und die Antriebe mit einer Signalanalyseeinheit gekoppelt sind, die eine Veränderung des Resonanzsignals bei Kontakt mit einem Objekt auswertet. Durch die einfache Überlagerung des Antriebssignals mit dem Resonanzsignal und einer Auswertung eines ausgekoppelten Signals hinsichtlich der Amplitude und der Phasenlage gegenüber dem eingekoppelten Resonanzsignals ist es möglich, eine exakte Bestimmung des Ortes der Berührung des Endeffektors mit einem Objekt und gegebenenfalls der Berührungskraft durchzuführen.

Bevorzugt sind die Antriebe Linearantriebe und insbesondere piezoelektrische Antriebe ausgebildet, die eine präzise und hinreichend feine Verlagerung der Anlenkpunkte an dem Endeffektor ermöglichen, so dass dieser in Richtung auf das zu ertastende oder zu greifende Objekt verlagert werden kann. Die Antriebe können über Gelenke mit dem Endeffektor gekoppelt sein und sind bei einer zweidimensionalen Ausrichtung der Bewegung des Endeffektors bevorzugt symmetrisch an dem Endeffektor angeordnet. Sofern mehrere Antriebe vorgesehen sind, können diese ebenfalls symmetrisch an dem Endeffektor angeordnet sein. Für eine flächige oder räumliche Beweglichkeit kann der Endeffektor Teil eines piezoelektrischen Biegewandlers sein. Eine Ausgestaltung der Erfindung sieht vor, das der Endeffektor Teil einer Mittelelektrode oder an der Mittelelektrode des Biegewandlers angeordnet ist, die zwischen zwei Piezokeramiken und zwei Außenelektroden eingebettet ist. Alternativ sind die Antriebe Teil eines einteiligen Piezoröhrchens, das durch entsprechende Beaufschlagung an den Piezokeramiken zu einer entsprechenden Verlagerung des Endeffektors führt. Eine besonders einfache Ansteuerung ergibt sich, wenn der Endeffektor zentrisch in dem Piezoröhrchen angeordnet oder an einem Ende des Röhrchens angeklebt ist.

Die Antriebe sind über den Endeffektor mechanisch miteinander gekoppelt, so dass über das Signalanalysesystem die entsprechenden eingespeisten und ausgekoppelten Signale oder Frequenzen, die auf einen Antrieb aufgebracht werden können, analysiert werden.

Um einen möglichen vibrationsfreien Betrieb des Systems zu ermöglichen, liegt die Frequenz des Resonanzsignals im Bereich der Resonanzfrequenz des mechanischen Gesamtsystems, wobei die Spannung klein gegenüber den Spannungsamplituden der Antriebssignale der jeweiligen Antriebe ist.

Das erfindungsgemäße Verfahren zur Bestimmung der Kontaktkraft oder der Position eines Endeffektors, insbesondere eines Mikromanipulators zu einem Objekt, der zumindest zwei elektrische Antriebe aufweist, die gegeneinander beweglich sind, sieht vor, dass die Antriebe über einen Anlenkpunkt mit dem Endeffektor gekoppelt sind und mit einem Antriebssignal beaufschlagt werden, wobei ein Antrieb mit einem Frequenzgenerator gekoppelt ist und mit einem Resonanzsignal zusätzlich zu dem Antriebssignal beaufschlagt wird und eine Phasen- und/oder Amplitudenänderung des Resonanzsignals bei Kontakt des Endeffektors mit dem Objekt ausgewertet wird.

Nachfolgend wird ein Ausführungsbeispiel der Erfindung anhand der beigefügten Figuren näher erläutert. Es zeigen:
- Figur 1 -: eine prinzipielle Darstellung des mechanischen Aufbaus der Vorrichtung;
- Figur 2 -: ein elektrisches Blockschaltbild für den Antrieb und die Kraftmessung in zwei Raumdimensionen;
- Figur 3 -: ein Beispiel eines Endeffektors; sowie
- Figur 4 -: eine alternative Ausgestaltung eines Endeffektors .

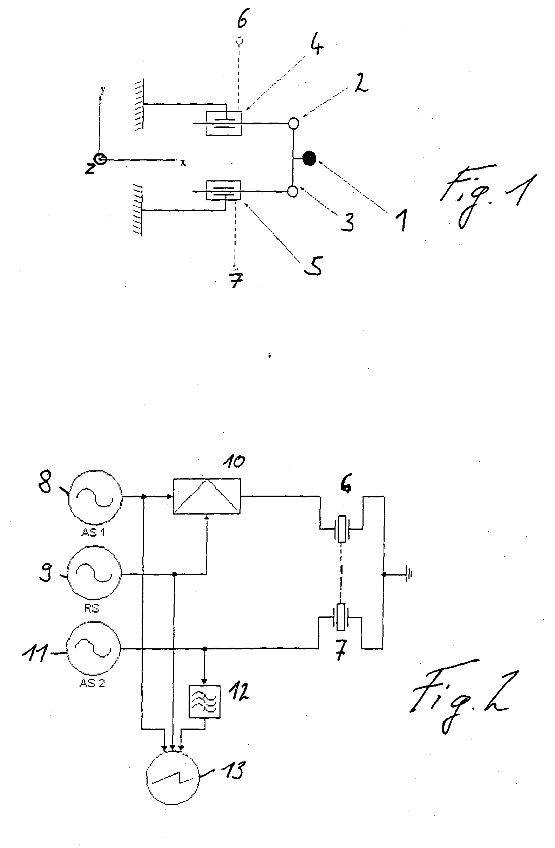

In der Figur 1 ist der mechanische Aufbau eines Antriebssystems für einen Endeffektor 1, der über zwei Anlenkpunkte 2, 3, die als Gelenke ausgebildet sein können, mit zwei Antrieben 4 und 5 gekoppelt. Die Antriebe 4, 5 werden über entsprechende Anschlüsse 6, 7 mit elektrischer Energie versorgt und sind über die Gelenke 2,3 und den Endeffektor 1, der bei einem Handhabungsgerät auch ein Tool Center Point (TCP) oder Tool Connector Point sein kann, mechanisch miteinander gekoppelt. Die Antriebe 4, 5 können separat angesteuert werden. Somit ist es möglich, den Endeffektor 1 in Richtung der X-Achse zu verschieben, wenn beide Antriebe 4, 5 gleichgerichtet geschaltet werden. Wird nur ein Antrieb 4, 5 betätigt oder werden die Antriebe 4, 5 gegenläufig angesteuert, kann eine Drehung um die Z-Achse erfolgen, so dass ein mehrachsiger Antrieb für den Endeffektor 1 bereitgestellt werden kann. Bei drei räumlich versetzt zueinander angeordneten Antrieben ist es möglich, bei einer entsprechenden Anordnung einer Kopplungseinrichtung zwischen den Anlenkpunkten eine dreidimensionale Verlagerung des Endeffektors 1 zu erreichen.

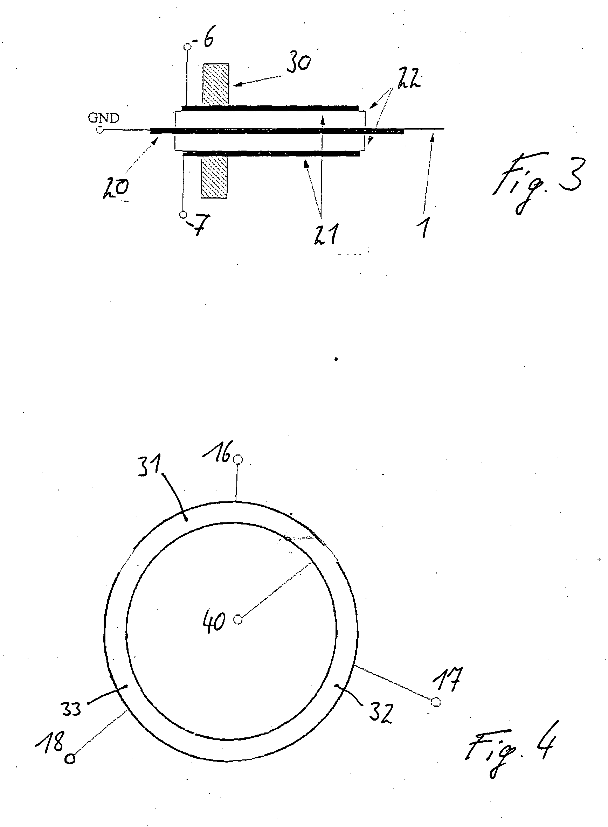

Die Ansteuerung der Antriebe 2, 3 über die jeweiligen Anschlüsse 6, 7 erfolgt gemäß dem elektrischen Blockschaltbild, wie es in der Figur 2 dargestellt ist. Ein erster Frequenzgenerator 8 erzeugt ein Antriebssignal AS1 für den ersten Antrieb 4. Ein zweiter Frequenzgenerator 8 erzeugt ein Resonanzsignal RS mit einer Amplitude U und einer Frequenz f, das dem ersten Antriebssignal AS1 additiv überlagert und an den Anschluss 6 des ersten Antriebs 4 weiterleitet. Das Resonanzsignal RS und das erste Antriebssignal AS1 werden in einem Mischer 10 überlagert. Das zweite Antriebssignal AS2 wird in einem Frequenzgenerator 11 an den Anschluss 7 des zweiten Antriebs 5 geleitet. Durch die mechanische Verkopplung der Antriebe 4, 5 durch den Endeffektor 1 wird das Resonanzsignal RS auf den Antriebsstrang des zweiten Antriebes 5 übertragen und kann so über einen Bandfilter 12 ausgekoppelt und in einer Systemanalyseeinheit 13 analysiert werden. Dabei wird das Resonanzsignal RS so gewählt, dass dessen Frequenz f im Bereich der Resonanzfrequenz des mechanischen Systems, wie es in der Figur 1 dargestellt ist, liegt und die Spannung U klein gegenüber den Spannungsamplituden der Antriebssignale AS1 und AS2 ist. Dies ermöglicht einen vibrationsfreien Betrieb des Systems. Filterparameter werden so gewählt, dass nur das Resonanzsignal RS auf die Signalanalyseeinheit 13 übertragen wird. Die Signalanalyseeinheit 13 wertet außerdem die Antriebssignale AS1 und AS2 der beiden Antriebe 4, 5 aus.

Durch eine entsprechende Wahl der Antriebssignale AS1, AS2 nach Amplitude, Frequenz und Phase zueinander werden die Antriebe 4, 5 so angesteuert, dass der Endeffektor 1 eine bestimmte Bahnkurve oder gerade Bewegung beschreibt. Dabei sind insbesondere halbkreisförmige oder kreisförmige Bahnen sinnvoll.

Durch die Wahl des von dem Frequenzgenerator 9 erzeugten Resonanzsignals RS in der Resonanzfrequenz des mechanischen Gesamtsystems wird sich der am TCP angebrachte Endeffektor, z. B. ein Greifer oder ein Messtaster, zusätzlich mit der Resonanzfrequenz bewegen. Bei einer Berührung des Endeffektors mit einem anderen Objekt wird die Amplitude des nach dem Bandfilter 12 ausgekoppelten Signals gedämpft und die Phasenlage gegenüber dem eingekoppelten Resonanzsignal RS verschoben. Diese Amplituden- und Phasenänderung wird von der Signalanalyseeinheit 13 ausgewertet und mit den beiden Antriebssignalen AS1, AS2 korreliert. Dadurch ist eine exakte Bestimmung des Ortes der Berührung in TCP-Koordinaten sowie der Berührungskraft möglich.

Durch die Erweiterung des mechanischen Systems um eine dritte Achse ist außerdem eine Detektion der Berührung und der Kontaktkraft in einer weiteren Raumdimension möglich. Durch eine entsprechende Wahl der Antriebssignalamplituden und der Resonanzsignalamplitude zueinander ist es möglich, Ortsauflösungen im SubMikrometerbereich zu realisieren.

In der Figur 3 ist schematisch der Aufbau eines piezoelektrischen Biegewandlers in einer Bimorph-Bauweise mit einem montierten Endeffektor 1 in Gestalt eines Mikrogreifers dargestellt. Der Mikrogreifer 1 ist an einer Mittelelektrode 20 angeordnet, die von zwei Piezokeramiken 22 umgeben ist, die wiederum von einer Außenelektrode 21 eingeschlossen ist. Die Außenelektroden 21 sind in einer Einspannung 30 gehalten. In den Außenelektroden 21 sind die Anschlüsse 6, 7 für die Antriebssignale AS1, AS2 sowie das Resonanzsignal RS angebracht. Die Piezokeramiken 22 bilden zusammen mit den Elektroden 20, 21 die Antriebe 4, 5, der Austritt der Mittelelektrode 20 aus den Piezokeramiken 22 stellt die Anlenkpunkte 2, 3 dar. Der Biegewandler kann durch die Ansteuerung der beiden Piezokeramiken 22 in X-Richtung durch eine Dehnung bzw. Stauchung beider Keramiken als auch in Y-Richtung durch eine Dehnung der einen und Stauchung der anderen Keramik 22 ausgelenkt werden. Die beiden Keramiken 22 werden mit zwei phasenversetzten, sinusförmigen Wechselspannungen bewegt, so dass der Endeffektor oder Greifer 1 insgesamt eine Kreisbahn beschreibt.

Durch die Überlagerung eines höherfrequenten Resonanzsignals RS mit geringer Amplitude auf die obere Keramik 22 mittels des Anschlusses 6 wird diese Schwingung aufgrund der mechanischen Verkopplung auch auf die untere Keramik 22 übertragen, der der untere Anschluss 7 zugeordnet ist. Dort erzeugt die Schwingung ein elektrisches Signal, das proportional zur angeregten Schwingung ist. Die Frequenz und die Spannung des am Anschuss 7 ausgekoppelten Signals werden dann in der Signalanalyseeinheit 13 ausgewertet.

Beim Antasten an ein anderes Objekt ist die Position des Endeffektors 1 oder der Greiferspitze durch die Auswertung der Antriebssignale AS1, AS2 auf die beiden Piezoantriebe 4, 5 bekannt. Durch das Messen der Amplitude des Resonanzsignals RS ist es somit möglich, der ermittelten Position des Endeffektors 1 einen Spannungswert zuzuordnen. Verändert sich dieser Spannungswert in Amplitude oder Phasenlage, hat der Endeffektor 1 Kontakt zu einem anderen Objekt. Durch das Maß der Veränderung des Spannungswertes ist es möglich, die Kontaktkraft oder Greifkraft des Endeffektors 1 zu bestimmen.

Eine alternative Ausgestaltung der Vorrichtung ist in der Figur 4 dargestellt, bei der ein einteiliges piezoelektrisches Röhrchen drei Antriebssegmente 31, 32, 33 ausbildet, indem drei elektrisch voneinander getrennte Anschlüsse 16, 17, 18 auf dem Außenumfang des Piezoröhrchens angebracht sind und nach Wunsch angesteuert werden können. Innen liegt die Mittelelektrode 40, vorliegend als Rohr ausgebildet. An einem Ende des Röhrchens wird der Endeffektor befestigt, beispielsweise angeklebt. Durch die Segmentierung der Ansteuerung des Piezoröhrchens ist es möglich, den Endeffektor in drei Richtungen im Raum zu bewegen. Die drei Bereiche 31, 32, 33 des Piezoröhrchens werden in geeigneter Weise durch die Elektrode 16, 17, 18 angesteuert, so dass der Endeffektor die gewünschte Bahnkurve beschreibt. Dies kann im vorliegenden Fall eine halbkugelflörmige Bewegung sein. Dabei wird die Amplitude der Bewegung so gewählt, dass sie klein gegenüber den Abmessungen der Spitze bzw. des Endeffektors ist.

Auf einen der Anschlüsse 16, 17, 18 des Piezoröhrchens wird zusätzlich das höherfrequente Resonanzsignal in Gestalt einer Wechselspannung eingekoppelt. Dabei wird die Frequenz so gewählt, dass sie im Resonanzbereich des Aufbaus liegt. Die Amplitude des Resonanzsignals wird jedoch wesentlich kleiner als die Amplitude der Antriebssignale gewählt, um bei einer Kraftmessung eine möglichst geringe Ortsunschärfe zu erhalten. Durch die mechanische Verkopplung der Anschlüsse über das Piezoröhrchen wird die angeregte Schwingung, beispielsweise an dem Antriebssegment 31 durch den Anschluss 16, auch auf die anderen beiden Antriebssegmente 32, 33 und die Anschlüsse 17, 18 übertragen. Von einem dieser Anschlüsse 17, 18 wird das andere Signal ausgekoppelt und elektrisch ausgewertet. Bei einer Berührung der Tastspitze als Endeffektor, beispielsweise auf der Oberfläche eines zu vermessenden Objektes, kann sowohl der Ort als auch die Kraft der Berührung gemessen werden. Bei einem Einsatz geeignet kleiner Tastspitzen kann somit eine Messauflösung unterhalb der Spitzenabmessungen des Endeffektors mit einfachen Mitteln erreicht werden.

Durch die erfindungsgemäße Vorrichtung und das erfindungsgemäße Verfahren könne Endeffektoren oder Tastspitzen gleichzeitig als Sensoren verwendet werden, verwendet werden, so dass minimale Abmessungen im µm-Bereich und die Anwendung in der Mikromanipulatortechnik möglich sind. Ein separater Sensor oder eine besondere Ausgestaltung des Endeffektors ist nicht notwendig, vielmehr können die für den jeweiligen Einsatzzweck optimalen Gestaltungen ohne Restriktionen eingesetzt werden.

## Patentansprüche

1. Vorrichtung zum Verlagern von Endeffektoren an Mess- oder Handhabungseinrichtungen mit zumindest zwei elektrischen Antrieben, die mit dem Endeffektor gekoppelt sind, **dadurch gekennzeichnet, dass** die Antriebe (4, 5; 31, 32, 33) über Anlenkpunkte (2, 3) mit dem Endeffektor (1) gekoppelt sind und eine Linearbewegung oder Rotationsbewegung ausüben, wobei zumindest ein Antrieb (4, 5; 31, 32, 33) mit einem Frequenzgenerator (8, 9, 11) gekoppelt und mit einem Resonanzsignal (RS) zusätzlich zu einem Antriebssignal (AS1) beaufschlagt ist und die Antriebe (4, 5; 31, 32, 33) mit einer Signalanalyseeinheit (13) gekoppelt sind, die eine Veränderung des Resonanzsignals (RS) bei Kontakt mit einem Objekt auswertet.

2. Vorrichtung nach Anspruch 1, **dadurch gekennzeichnet, dass** die Antriebe (4, 5; 31, 32, 33)Linearantriebe sind.

3. Vorrichtung nach Anspruch 1 oder 2, **dadurch gekennzeichnet, dass** die Antriebe (4, 5; 31, 32, 33) als piezoelektrische Antriebe ausgebildet sind.

4. Vorrichtung nach einem der voranstehenden Ansprüche, **dadurch gekennzeichnet, dass** die Antriebe (4, 5; 31, 32, 33) über Gelenke (2, 3) mit dem Endeffektor (1) gekoppelt sind.

5. Vorrichtung nach einem der voranstehenden Ansprüche, **dadurch gekennzeichnet, dass** die Antriebe (4, 5; 31, 32, 33) symmetrisch an dem Endeffektor (1) angeordnet sind.

6. Vorrichtung nach einem der voranstehenden Ansprüche/Anspruch, **dadurch gekennzeichnet, dass** der Endeffektor (1) Teil eines piezoelektrischen Biegewandlers ist.

7. Vorrichtung nach Anspruch 6, **dadurch gekennzeichnet, dass** der Endeffektor (1) Teil einer Mittelelektrode (20, 40) oder an der Mitteleelektrode (20, 40) des Biegewandlers angeordnet ist, die zwischen zwei Piezokeramiken (21) und zwei Außenelektroden (22) eingebettet ist.

8. Vorrichtung nach einem der Ansprüche 1 bis 5, **dadurch gekennzeichnet, dass** die Antriebe (4, 5; 31, 32, 33) als Teil eines Piezoröhrchens ausgebildet sind.

9. Vorrichtung nach Anspruch 8, **dadurch gekennzeichnet, dass** der Endeffektor (1) zentrisch in dem Piezoröhrchen angeordnet ist.

10. Vorrichtung nach einem der voranstehenden Ansprüche, **dadurch gekennzeichnet, dass** die Antriebe (4, 5; 31, 32, 33) über den Endeffektor (1) mechanisch miteinander gekoppelt sind.

11. Vorrichtung nach einem der voranstehenden Ansprüche, **dadurch gekennzeichnet, dass** das Resonanzsignal (RS) im Bereich der Resonanzfrequenz des mechanischen Systems aus Antrieben (4, 5; 31, 32, 33) und Endeffektor (1) liegt.

12. Verfahren zur Bestimmung der Kontaktkraft oder der Position eines Endeffektors, insbesondere eines Mikromanipulators, zu einem Objekt, der zumindest zwei elektrische Antriebe aufweist, die gegeneinander beweglich sind, **dadurch gekennzeichnet, dass** die die Antriebe über Anlenkpunkte mit dem Endeffektor gekoppelt sind und mit einem Antriebssignal beaufschlagt werden, wobei ein Antrieb mit einem Frequenzgenerator gekoppelt und mit einem Resonanzsignal zusätzlich zu dem Antriebssignal beaufschlagt wird und die Phasen- und /oder Amplitudenänderung des Resonanzsignals bei Kontakt des Endeffektors mit dem Objekt ausgewertet wird

13. Verfahren nach Anspruch 12, **dadurch gekennzeichnet, dass** das Resonanzsignal im Bereich der Resonanzfrequenz des mechanischen Gesamtsystems liegt.

14. Verfahren nach Anspruch 12 oder 13, **dadurch gekennzeichnet, dass** die Amplitude des Resonanzsignals im Vergleich zu dem Antriebssignal klein ist.
